# EUROPÄISCHE PATENTSCHRIFT

(11) **EP 3 794 642 B1**
(45) Veröffentlichungstag und Bekanntmachung des Hinweises auf die Patenterteilung: **02.07.2025**
(21) Anmeldenummer: 19724782.8
(22) Anmeldetag: 14.05.2019
(51) Int. Cl.: H01L 23/29, H01L 25/07, H01L 25/10, H01L 25/16, H01L 25/18, H01L 23/538, H01L 23/00, H01L 25/00, H01L 23/31

(54) **ELEKTRONIKMODUL UND VERFAHREN ZUR HERSTELLUNG DESSELBEN**
ELECTRONICS MODULE AND METHOD FOR PRODUCING IT
MODULE ÉLECTRONIQUE ET SON PROCÉDÉ DE FABRICATION

(30) Priorität: 18.05.2018 DE 102018111989
(43) Veröffentlichungstag der Anmeldung: 24.03.2021
(73) Patentinhaber: Rogers Germany GmbH, 92676 Eschenbach (DE)
(72) Erfinder: SCHMIDT, Karsten, 92676 Eschenbach (DE); MEYER, Andreas, 95469 Speichersdorf (DE); HOENE, Eckart, 13465 Berlin (DE); MARCZOK, Christoph, 10365 Berlin (DE); THOMAS, Tina, 10439 Berlin (DE); KAHLE, Ruben, 13409 Berlin (DE)
(74) Vertreter: Müller Schupfner & Partner Patent- und Rechtsanwaltspartnerschaft mbB (Muc)
(86) Internationale Anmeldenummer: PCT/EP2019/062294
(87) Internationale Veröffentlichungsnummer: WO 2019/219650

(56) Entgegenhaltungen:
- DE-A1- 102016 000 264
- US-A1- 2011 128 707
- US-A1- 2015 303 164
- US-A1- 2017 018 478
- US-A1- 2018 053 745

## Beschreibung

Die vorliegende Erfindung betrifft ein Elektronikmodul und ein Verfahren zu dessen Herstellung.

Elektronikmodule sind aus dem Stand der Technik, beispielsweise als Leistungselektronikmodule, hinlänglich bekannt. Solche Elektronikmodule nutzen typischerweise schaltbare Elektronikbauteile, die auf einem gemeinsamen Trägersubstrat über Leiterbahnen miteinander verschaltet sind. Wesentliche Bestandteile des Trägersubstrats sind dabei eine Isolationsschicht, die beispielsweise im Falle eines Metall-Keramik-Substrats aus einem eine Keramik umfassenden Material gefertigt ist, und eine Metallisierungsschicht, die zur Bildung von Leiterbahnen vorzugsweise strukturiert und an einer Bauteilseite des Trägersubstrats ausgebildet ist.

Solche Elektronikmodule werden typischerweise für eine hohe Lebensdauer und hohe Betriebssicherheit so ausgelegt, dass möglichst thermisch induzierte mechanische Spannungen im Elektronikmodul vermieden werden und an der Bauteilseite entstehende Wärme möglichst optimal abgeleitet werden kann, vorzugsweise mittels einer hierzu vorgesehenen Kühlstruktur. Dabei stellen die Spezifikationen neuer elektronischer Bauteile, wie z. B. WBG-Halbleiter (wide bandgap semiconductors), insbesondere Halbleiter aus Siliziumcarbid, Galliumnitrid und/oder Indiumgalliumnitrid, die Elektronikmodule genauso vor neue Herausforderung wie neuartige Einsatzgebiete, z. B. im Bereich der E-Mobilität.

Aus dem Stand der Technik sind beispielsweise die Druckschriften DE 10 2008 029 829 B4, DE 10 2009 042 399 A1, US 7 589 412 B2 und DE 10 2014 117 086 A1, in denen elektrische Bauteile zur Ausbildung eines Elektronikmoduls auf einem Trägersubstrat angeordnet und in einer Verkapselung eingebettet sind. Ein weiteres Beispiel für ein Elektronikmodul ist das von Anlog Devices vertriebene Bauteil mit der Bezeichnung "LTM4636".

Ferner kennt der Stand der Technik Verkapselungen für Leiterbahnen und deren Träger aus der US 2018 0 053 745 A1, US 2011 128 707 A1, DE 10 2016 000 264 und US 20150 303 164 A1. Aus der US 2017 0 018 478 A1 ist eine mehrlagige Anordnung von Halbleitern bekannt, die über Durchkontaktierungen miteinander verbunden sind.

Ausgehend von diesem Stand der Technik macht es sich die vorliegende Erfindung zur Aufgabe, ein Elektronikmodul bereitzustellen, das gegenüber denen aus dem Stand der Technik verbessert ist, insbesondere in Hinblick auf dessen Bauform, Schaltverhalten und Lebensdauer.

Die Aufgabe wird erfindungsgemäß durch ein Elektronikmodul gemäß Anspruch 1 und ein Verfahren zur Herstellung eines Elektronikmoduls gemäß Anspruch 13 gelöst. Bevorzugte Ausgestaltungen der Erfindung sind in den abhängigen Ansprüchen sowie der nachfolgenden Beschreibung, insbesondere im Zusammenhang mit den beiliegenden Figuren, angegeben.

Erfindungsgemäß ist ein Elektronikmodul vorgesehen, das eine Verkapselung und ein zumindest teilweise in die Verkapselung eingebettetes Trägersubstrat mit einer Bauteilseite, die eine erste Metallisierungsschicht aufweist und an der mindestens ein erstes elektronisches Bauteil angeordnet ist, umfasst, wobei an einer Außenseite der Verkapselung mindestens eine zweite Metallisierungsschicht für mindestens ein zweites elektronisches Bauteil, insbesondere zur Steuerung des ersten elektronischen Bauteils, vorgesehen ist und wobei die Verkapselung mindestens eine Durchkontaktierung zur elektrischen Verbindung, insbesondere zur unmittelbaren elektrischen Verbindung, des ersten elektronischen Bauteil und des zweiten elektronischen Bauteils aufweist.

Im Gegensatz zum Stand der Technik ist es erfindungsgemäß vorgesehen, dass die Verkapselung das Trägersubstrat z. B. in Form eines Gussmaterials zumindest teilweise umgibt bzw. das Trägersubstrat in der Verkapselung eingebettet ist und mit der Durchkontaktierung eine Möglichkeit zur elektrischen Verbindung zwischen dem ersten elektrischen Bauteil und dem zweiten elektrischen Bauteil bereitgestellt wird. Dabei erstreckt sich die Durchkontaktierung von der Außenseite, insbesondere von der als Anschluss für die zweiten elektronischen Bauteile dienenden zweiten Metallisierungsschicht, bis zum ersten elektronischen Bauteil und/oder zur ersten Metallisierungsschicht auf der Bauteilseite des Trägersubstrats. Infolgedessen entsteht nicht nur ein kompaktes Elektronikmodul, sondern es wird ein vergleichsweise geringer Abstand zwischen dem ersten elektronischen Bauteil auf der Bauteilseite einerseits und den zweiten elektronischen Bauteilen auf der Außenseite andererseits bereitgestellt. Insbesondere zeichnet sich die Erfindung durch die zweite Metallisierungsschicht aus, die ein unmittelbares Anbinden an der Außenseite der Verkapselung gestattet.

Vorzugsweise ist es vorgesehen, dass ein senkrecht zur Haupterstreckungsebene bemessener Abstand zwischen der ersten Metallisierungsschicht und der zweiten Metallisierungsschicht kleiner als 5 mm, bevorzugt geringer als 2,5 mm und besonders bevorzugt geringer als 1 mm bis hin zu weniger als 400 µm, beispielsweise in etwa 300 µm, ist, d. h. möglichst gering ist. Entsprechend stellt sich in einer senkrecht zur Haupterstreckungsebene verlaufenden Richtung ein sehr kurzer Abstand zwischen dem ersten Bauteil und dem weiten Bauteil ein. Weiterhin sind die Durchkontaktierungen in die Verkapselung eingelassen, d. h. zeitlich nach dem Verkapseln werden die Durchkontaktierungen realisiert. Dabei können die Durchkontaktierungen nasschemisch, durch eine Paste, eine Gasphasenabscheidung, ein Siebdruckverfahren, ein 3D-Druckverfahren mechanisch und/oder galvanisch realisiert werden. Weiterhin ist es bevorzugt vorgesehen, dass die erste Metallisierungsschicht und die zweite Metallisierungsschicht so strukturiert sind, dass in einer parallel zur Haupterstreckungsebene verlaufenden Richtung das erste Bauteil und das zweite Bauteil um einen lateralen Abstand zueinander versetzt sind.

Dadurch wird in vorteilhafter Weise vermieden, dass die Wärmeentwicklung des ersten und des zweiten Bauteils sich gegenseitig beeinflussen bzw. beeinträchtigen. Für eine wirkungsvolle Ansteuerung des ersten Bauteils durch das zweite Bauteil zu gewährleisten, ist es vorzugsweise vorgesehen, dass der laterale Abstand kleiner ist als 35 mm, bevorzugt kleiner als 15 und besonders bevorzugt kleiner als 5 mm.

Unter einem "Einbetten" bzw. "eingebettet sein" ist insbesondere ein unmittelbares Angrenzen der Verkapselung an einer Außenseite des Trägersubstrats zu verstehen, d. h. die Verkapselung liegt zumindest bereichsweise unmittelbar flächig am Trägersubstrat an und es wird kein lichter Bereich bzw. Hohlraum zwischen dem mit dem elektronischen Bauteil bestückten Trägersubstrat und der Verkapselung ausgebildet. Dabei muss das Trägersubstrat nicht an allen Seiten von der Verkapselung ummantelt bzw. umgeben sein. Ferner ist es vorgesehen, dass die Verkapselung massiv ist, d.h. frei von Hohlräumen.

Weiterhin ist es vorzugsweise vorgesehen, dass die Durchkontaktierung jeweils einen in einer parallel zur Haupterstreckungsebene bemessenen Richtung bemessenen Querschnitt von weniger als 5 mm² aufweist, bevorzugt weniger als 1,5 mm² und besonders bevorzugt weniger als 0,5 mm², insbesondere wenn die Durchkontaktierung unmittelbar an das erste Bauteil, insbesondere an eine Oberseite des ersten Bauteils, angebunden ist. Sollte die Durchkontaktierung an der ersten Metallisierungsschicht angebunden sein, ist der Querschnitt vorzugsweise kleiner als 1,5 mm², bevorzugt kleiner als 2,5 mm² und besonders bevorzugt kleiner als 1,5 mm². Da sich der Querschnitt in Stapelrichtung gesehen aus fertigungstechnischen Gründen verändern, insbesondere verjüngen kann, ist als Querschnitt vorzugsweise dessen Durchschnitt entlang seiner Erstreckung in Stapelrichtung zu verstehen.

Weiterhin ist es vorgesehen, dass die Durchkontaktierung bündig mit der Außenseite der Verkapselung abschließt. Der bündig an die Durchkontaktierung anschließende Teil der zweiten Metallisierungsschicht weist weiterhin eine parallel zur Haupterstreckungsebene bemessene Kontaktfläche auf. Ein Verhältnis zwischen einem parallel zur Haupterstreckungsebene bemessenen Querschnitt der Durchkontaktierung zur Kontaktfläche des sich an die Durchkontaktierung anschließenden Teils der zweiten Metallisierungsschicht nimmt vorzugsweise einen Wert kleiner als 0,25, bevorzugt kleiner als 0,15 und besonders bevorzugt kleiner als 0,1 an. Mit anderen Worten: die Durchkontaktierung ist vergleichsweise schmal ausgestaltet. Weiterhin ist es vorstellbar dass mehrere Durchkontaktierungen mit einem gemeinsamen elektronischen Bauteil verbunden sind und der aufsummierte Querschnitt aller Durchkontaktierungen kleiner ist als die Kontaktfläche der zweiten Metallisierungsschicht.

Die Durchkontaktierungen zeichnen sich weiterhin bevorzugt dadurch aus, dass zumindest ein Teil aller Durchkontaktierungen in Stapelrichtung gesehen oberhalb der ersten elektronischen Bauteile bzw. zwischen den ersten elektronischen und den zweiten elektronischen Bauteilen angeordnet sind. Dabei ist es vorstellbar, dass ein erster Teil aller Durchkontaktierungen die ersten Bauteile unmittelbar kontaktiert und ein zweiter Teil aller Durchkontaktierungen die erste Metallisierungsschicht kontaktiert. Vorzugsweise ist der zweite Teil größer als der erste Teil. Die Kontaktierung des ersten Bauteils und des zweiten Bauteils über die Durchkontaktierung kann direkt oder indirekt bzw. mittelbar erfolgen. Beispielsweise kann das erste Bauteil selbst in einem Vorverbund integriert sein oder die Durchkontaktierung kontaktiert die erste Metallisierungsschicht um eine elektrische Verbindung zwischen dem ersten Bauteil und dem zweiten Bauteil zu realisieren.

Vorzugsweise bleibt zumindest eine Außenseite des Trägersubstrats frei von der Verkapselung. Insbesondere ist es vorgesehen, dass zumindest die Bauteilseite des Trägersubstrats vollständig verkapselt ist, d. h. bedeckt bzw. umschlossen ist von der Verkapselung. Erfindungsgemäß ist es vorgesehen, dass eine Außenfläche zu mehr als 50 % und bevorzugt mehr als 60 % von der Verkapselung bedeckt ist. Durch die unmittelbare Anbindung an das Trägersubstrat bzw. das Einbetten des Trägersubstrats in der Verkapselung wird in vorteilhafter Weise auch die Stabilität des Elektronikmoduls verbessert und es kann auf zusätzliche Maßnahmen zur Stabilisierung z. B. zwischen der Verkapselung und dem Trägersubstrats verzichtet werden. Denkbar ist auch, dass zwischen den ersten elektronischen Bauteilen und der Verkapselung eine Schutzschicht vorgesehen ist, die die ersten elektronischen Bauteile verkleidet bzw. schützt und durch die die Durchkontaktierung, und/oder weitere Durchkontaktierungen verlaufen.

Als erste elektronische Bauteile sind vorzugsweise schaltbare Bauteile bzw. aktive Bauteile zu verstehen. Vorzugsweise handelt es sich bei zumindest einem ersten elektrischen Bauteil um eines mit einem WBG-Halbleiter (wide bandgap semiconductors), wie z. B. einem Halbleiter aus Siliziumcarbid, Galliumnitrid und/oder Indiumgalliumnitrid. Beispiele für ein elektronisches Bauteil sind MOSFETs ("metal-oxide-semiconductor field-effect transistor") oder IGBTs ("insulated-gate bipolar transistor"). Die ersten Bauteile können auch als Vorverbund bzw. "Prepackaging" zusammengefasst sein. In einem solchen Vorverbund sind ein oder mehrere erste elektronische Bauteile beispielsweise auf einer Leiterplatte angeordnet und in einer Matrix eingebettet. Ein Beispiel für ein Vorverbund findet sich in der Druckschrift DE 10 2014 117 086 A1 als Umverteilungsstruktur, bei der ein elektrisches Bauteil in eine dielektrische Matrix integriert ist. Auf den Offenbarungsgehalt der DE 10 2014 117 086 A1 bezüglich des Vorverbunds bzw. der Umverteilungsstruktur wird hiermit explizit Bezug genommen. Weitere Beispiele für einen Vorverbund auf die explizit Bezug genommen wird, sind in den Artikeln "Development of Embedded Power Electronics Modules für Automotive Applications" von L. Boettcher et al. und "Embedding of Power Semiconductors for Innovative Packages and Modules" von L. Boettcher et al. zu finden.

Als zweite elektronische Bauteile und/oder Kontaktelemente sind vorzugsweise
- Treiber - bzw. Steuerelemente, insbesondere "Gate treiber", und/oder
- Anschlussvorrichtungen, die z. B. als Lastanschluss für ein Eingangssignal oder zur Energieversorgung dienen, und/oder
- Kondensatoren, beispielsweise Zwischenkondensatoren vorgesehen und werden insbesondere unmittelbar auf die als Anschluss dienende zweite Metallisierungsschicht kontaktiert, z. B. aufgelötet bzw. aufgesintert. Unter einem "Gate-Treiber", z. B. einem MOSFET-Treiber, IGBT-Treiber oder Halbbrücken-Treiber, versteht man insbesondere eine diskrete oder integrierte elektronische Schaltung, welche Leistungsschalter, wie beispielsweise MOSFETs oder IGBTs, ansteuert. Im Falle von Steuerelementen als zweite elektronische Bauteile, lassen sich so die ersten elektronischen Bauteile auf der Bauteilseite verbessert ansteuern, da in vorteilhafter Weise auf lange Übertragungswege für das Ansteuersignal vom Steuerelement an der Außenseite zum anzusteuernden ersten elektronischen Bauteil verzichtet werden kann. Ein weiterer Vorteil, der sich aus den vergleichsweise kurzen Leiterbahnen ergibt, ist eine Reduktion von parasitären Induktivitäten, mit denen andernfalls zu rechnen wäre, wenn man keine Verkapselung und keine Durchkontaktierung für die elektrische Verbindung zwischen der Außenseite der Verkapselung und der Bauteilseite des Trägersubstrats vorsehen würde.

Als Durchkontaktierung bzw. als Via ist ein elektrischer Leitungspfad zu verstehen, der die Verkapselung durchgreift bzw. zwei gegenüberliegende Seiten der Verkapselung miteinander elektrisch leitend verbindet. Dabei kann die Durchkontaktierung aus demselben Metall bzw. Material gefertigt sein, wie die erste Metallisierungsschicht und/oder die zweite Metallisierungsschicht oder sich davon unterscheiden. Ferner ist es denkbar, dass die Durchkontaktierung vollständig oder nur teilweise mit einem leitenden Material gefüllt ist. Weiterhin verläuft die Durchkontaktierung vorzugsweise geradlinig. Dabei kann die Durchkontaktierung parallel oder schräg zu einer senkrecht zur Haupterstreckungsebene des Trägersubstrats erstreckenden Richtung verlaufen. Über die Durchkontaktierung lässt sich zudem eine Kontaktierung des ersten elektronischen Bauteils über eine dem Trägersubstrat abgewandte Seite bzw. über eine der Außenseite der Verkapselung zugewandten Seite realisieren, d. h. elektrische Anschlüsse lassen sich auch nach "oben" aus der Verkapselung herausführen. Im Falle eines Vorverbunds bzw. "Prepacking" ist es in vorteilhafter Weise möglich, an einer im verbauten Zustand der Außenseite zugewandten Seite des Vorverbunds eine vorverbundseitige Kontaktierungsfläche zu realisieren. Dabei bietet es sich in vorteilhafter Weise an, die vorverbundseitige Kontaktierungsfläche zu vergrößern, um eine Anbindung an die Durchgangskontaktierung in der Verkapselung zu erleichtern. Beispielsweise nimmt ein Verhältnis zwischen einem parallel zur Haupterstreckungsebene gemessenen Durchmesser der Durchkontaktierung zur der parallel zur Haupterstreckungsebene gemessenen vorverbundseitigen Kontaktierungsfläche einen Wert zwischen 0,1 und 1, bevorzugt zwischen 0,15 und 0,8 und bevorzugt zwischen 0,3 und 0,6 an.

Vorzugsweise ist es vorgesehen, dass die ersten elektronischen Bauteile im Elektronikmodul auf einer der Außenseite der Verkapselung, insbesondere der zweiten Metallisierungsschicht zugewandten Seite, einen Kontakt aufweisen und über diesem Kontakt mit der Durchkontaktierung verbunden sind.

Insbesondere ist es vorgesehen, dass die Verkapselung ein Gussteil ist und vorzugsweise aus einem Kunststoff mittels Gießen, z. B. Spritzgießen, gefertigt ist. Dabei wirkt die Verkapselung im zusammengesetzten Elektronikmodul form-, kraft- und/oder stoffschlüssig mit dem Trägersubstrat zusammen. Beispielsweise umfasst die Verkapselung eine Hinterschneidung bzw. einen nasenartigen Vorsprung, über den die Verkapselung mit dem bestückten Trägersubstrat formschlüssig zusammenwirken kann. Insbesondere lässt sich die Verkapselung mit dem Trägersubstrat verclipsen bzw. ist mit dem Trägersubstrat, bevorzugt an dessen der Bauteilseite gegenüberliegenden Seite, die erfindungsgemäß zu Kühlzwecken genutzt wird, verclipst. Geeignete Gussmaterialien, auch Moldmasse genannt, sind Gießharze wie z. B. synthetische Duroplaste. Bevorzugt ist die Verkapselung aus einer Epoxid-Vergusskomponente als Verkapselungsmaterial gefertigt. Dabei hat die Vergusskomponete bevorzugt eine vergleichsweise hohe Glasübergangstemperatur, beispielswiese über 200 °C, eine Biegefestigkeit zwischen 10 und 15 kg/mm² und ist insbesondere aushärtbar. Beispielsweise handelt es bei dem Material um Hysol^{®} MG 15F-MOD2. Weiterhin ist es bevorzugt vorgesehen, dass dem Verkapselungsmaterial ein Füllmaterial, beispielsweise umfassend SiO₂ und/oder ein Aluminiumoxid, beigefügt ist.

Als Materialien für die erste Metallisierungsschicht bzw. die zweite Metallisierungsschicht sind Kupfer, Aluminium, Molybdän und/oder deren Legierungen, sowie Laminate wie CuW, CuMo, CuAl, AlCu und/oder CuCu, insbesondere eine Kupfersandwichstruktur mit einer ersten Kupferschicht und einer zweiten Kupferschicht, wobei sich eine Korngröße in der ersten Kupferschicht von einer zweiten Kupferschicht unterscheidet, vorstellbar. Weiterhin ist es bevorzugt vorgesehen, dass die erste Metallisierungsschicht und/oder die zweite Metallisierungsschicht oberflächenmodifiziert sind. Als Oberflächenmodifikation ist beispielsweise eine Versiegelung mit einem Edelmetall, insbesondere Silber und/oder Gold, oder ENIG ("Electroless nickel immersion gold") oder ein Kantenverguss an der ersten bzw. zweiten Metallisierungsschicht zur Unterdrückung einer Rissbildung bzw. -weitung denkbar.

Vorzugsweise ist die zweite Metallisierungsschicht strukturiert und/oder die ersten elektronischen Bauteile sind über die Durchkontaktierung durch mehrere zweite elektronische Bauteile ansteuerbar.

Erfindungsgemäß ist das Trägersubstrat ein Metall-Keramik-Substrat, wobei das Metall-Keramik-Substrat an seiner Bauteilseite eine strukturierte erste Metallisierungsschicht aufweist, wobei das Metall-Keramik-Substrat vorzugsweise mehrlagig ausgestaltet ist. Wesentliche Bestandteile der Metall-Keramik-Substrate sind eine Isolationsschicht, die aus einer Keramik gefertigt ist, und die an die Isolationsschicht angebundene Metallisierungsschicht. Wegen ihren vergleichsweise hohen Isolationsfestigkeiten haben sich aus Keramik gefertigte Isolationsschichten als besonders vorteilhaft erwiesen. Durch eine Strukturierung der ersten Metallisierungsschicht können sodann Leiterbahnen und/oder Anschlussflächen für die ersten elektrischen Bauteile realisiert werden. Insbesondere ist das Metall-Keramik-Substrat drei- oder fünflagig ausgestaltet. Durch die mehrlagige Ausgestaltung ist es in vorteilhafter Weise möglich vergleichsweise dicke metallische Zwischenschichten einzusetzen, während zur Stabilisierung mehrere Keramikschichten dienen. Infolgedessen lässt sich der Wärmewiderstand reduzieren und gezielt eine Wärmespreizung einstellen. Insbesondere ist es vorgesehen, dass die Schichtdicke der aus Keramik gefertigten Isolationsschicht an die geforderte Isolationsfestigkeit angepasst ist. Vorzugsweise weist die Isolationsschicht Al₂O₃, Si₃N₄, AIN, eine HPSX-Keramik (d. h. eine Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25), SiC, BeO, MgO, hochdichtes MgO (> 90% der theoretischen Dichte), TSZ (tetragonal stabilisiertes Zirkonoxid) oder ZTA als Material für die Keramik auf. Es ist dabei auch vorstellbar, dass die Isolationsschicht als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einer Isolationsschicht zusammengefügt sind. Vorzugsweise wird eine hochwärmeleitfähige Keramik für einen möglichst geringen Wärmewiderstand verwendet.

Vorzugsweise ist es vorgesehen, dass die Verkapselung einstückig bzw. integral bzw. monolithisch ausgestaltet ist. Unter "einstückig" ist insbesondere zu verstehen, dass die Verkapselung nicht zerstörungsfrei in weitere Einzelteile zerlegt werden kann. Dadurch bildet sich eine besonders stabile Verkapselung, die einen optimalen Schutz für die verkapselten Bauteile bereitstellt. Ferner ist es bevorzugt vorgesehen, dass die zweite Metallisierung im gefertigten Zustand des Elektromoduls an dessen Außenseite ausgebildet ist. Im gefertigten Zustand ist das Elektronikmodul nicht in eine weitere Verkapselung eingebettet, die beispielsweise die außenliegenden zweiten Elektronikbauteile verkapselt. Dies gestattet einen einfachen Zugriff auf die zweiten Elektronikbauteile an der Außenseite des gefertigten Elektronikmoduls. In einer weiteren Ausführungsform der vorliegenden Erfindung ist das gefertigte Elektromodul von einer abnehmbaren Verschalung umgeben, so dass auf einfache Weise die zweiten Elektronikbauteile zugänglich werden, indem man die Verschalung entfernt.

Vorzugsweise ist es vorgesehen, dass das Trägersubstrat eine Primärschicht, eine Sekundärschicht und eine zwischen der Primärschicht und der Sekundärschicht angeordnete metallische Zwischenschicht, insbesondere als elektronische Rückleiter, aufweist, wobei die Zwischenschicht vorzugsweise
- dicker als die Primärschicht und/oder die Sekundärschicht ist und/oder
- dicker als 1 mm, bevorzugt dicker als 1,5 und besonders bevorzugt dicker als 2,5 mm ist.

Derartig dicke metallische Zwischenschichten wirken in vorteilhafter Weise als temporärer Speicher und verbessern so die thermische Impedanz Zₜₕ. Dabei unterstützt die Dicke insbesondere die Wärmespreizung beim Wärmeabtransport, bei dem die Wärme von der Bauteilseite über das Trägersubstrat auf eine der Bauteilseite gegenüberliegende Seite des Trägersubstrats geleitet wird. Insbesondere ist es vorgesehen, dass die Zwischenschicht einlagig bzw. einstückig ausgestaltet ist. Die Zwischenschicht kann vorzugsweise als elektrische Rückleiter dienen, indem eine zusätzliche Durchkontaktierung in der Primärschicht eingelassen ist, so dass nicht nur die erste Metallisierungsschicht zur Stromführung genutzt werden kann, sondern auch die metallische Zwischenschicht.

Weiterhin ist es bevorzugt vorgesehen, dass das Trägersubstrat mit der Primärschicht, der Sekundärschicht und der metallischen Zwischenschicht als Aufbau aus fünf oder mehr Lagen zusammengesetzt ist. Insbesondere ist für den fünflagigen Aufbau vorgesehen das zwei metallische Zwischenschichten zwischen der Primärschicht und der Sekundärschicht vorgesehen sind, wobei zwischen den zwei metallischen Zwischenschichten eine Tertiärschicht angeordnet ist. Vorzugsweise weisen mindestens zwei Schichten ein vergleichsweise hohes E-Modul auf. Dadurch wird die Verwindungsneigung bei betriebs- und umgebungsbedingten Temperaturwechseln weiter reduziert. Vorzugsweise sind die Primärschicht, die Sekundärschicht und/oder die Tertiärschicht aus einem Keramik umfassenden Material gefertigt, beispielsweise aus einem der weiter oben genannten Keramiken. Dadurch lassen sich in vorteilhafter Weise die gewünschten Anforderungen an die Isolationsfestigkeit realisieren. Es ist aber auch vorstellbar, dass die Sekundärschicht und/oder Tertiärschicht nicht aus einem eine Keramik umfassenden Material gefertigt sind, da diese im Wesentlichen zur Versteifung des Trägersubstrats dienen und nicht zur Isolation beitragen. Denkbar wäre beispielsweise hier die Verwendung von Molybdän und/oder Wolfram statt einer Keramik.

**In** einer bevorzugten Ausführungsform der vorliegenden Erfindung ist es vorgesehen, dass das Elektronikmodul und/oder das Trägersubstrat thermomechanisch symmetrisch ausgestaltet ist, insbesondere entlang einer Stapelrichtung, die senkrecht zu einer Haupterstreckungsebene des Trägersubstrats verläuft. Unter einer thermomechanische symmetrischen Ausbildung ist insbesondere zu verstehen, dass thermomechanische Ausdehnungskoeffizienten in Stapelrichtung gesehen symmetrisch sind. Der thermomechanische Ausdehnungskoeffizient ist dabei ein Maß für die Ausdehnung der jeweiligen Schicht bei einem Temperaturwechsel bzw. einer Temperaturänderung. Vorzugsweise lässt sich das Elektronikmodul in virtuelle Teilsubstrate unterteilen, insbesondere mit einem virtuellen Primärsubstrat, einem virtuellen Sekundärsubstrat und einer virtuellen Zwischenschicht und die thermischen Ausdehnungskoeffizienten der virtuellen Teilsubstrate sind symmetrisch in Stapelrichtung verteilt. Durch die symmetrische Gestaltung der Ausdehnungskoeffizienten wird in vorteilhafter Weise ein Elektronikmodul bereitgestellt, das vergleichsweise verwindungsarm ist gegenüber betriebsbedingten bzw. umgebungsbedingten Temperaturwechseln. Infolgedessen lassen sich Defekte bzw. Risse vermeiden, die andernfalls durch thermisch induzierte mechanische Spannungen veranlasst werden würden. Insbesondere zusammen mit einem Trägersubstrat mit einer vergleichsweise dicken metallischen Zwischenschicht, insbesondere über 1 mm, ist es dabei möglich, einen vergleichsweise hohen thermischen Ausdehnungskoeffizienten für das gesamte Trägersubstrat bereitzustellen. Infolgedessen vereinfacht sich die Anpassung des thermischen Ausdehnungskoeffizienten für die Verkapselung des Elektronikmoduls, da der Aufwand zur Reduktion des typischerweise hohen thermischen Ausdehnungskoeffizienten der Verkapselung reduziert werden kann. Zum Reduzieren des thermischen Ausdehnungskoeffizienten wird schließlich ein Füllmaterial in das Material der Verkapselung eingelassen. Durch die erhöhten Ausdehnungskoeffizienten für das Trägersubstrat lässt sich die Menge des Füllmaterials reduzieren, wodurch wiederum Kosten für die Fertigung des Elektronikmoduls reduziert werden.

Erfindungsgemäß es vorgesehen, dass zur elektrischen Verbindung der Zwischenschicht mit dem zweiten elektronischen Bauteil eine weitere Durchkontaktierung vorgesehen ist, wobei die weitere Durchkontaktierung durch die Verkapselung und die Primärschicht verläuft. Dabei kann die weitere Durchkontaktierung durch die erste Metallisierungsschicht des Trägersubstrats verlaufen bzw. mehrere Teilabschnitte umfassen. Beispielsweise umfasst die weitere Durchkontaktierung einen Teilabschnitt in der Verkapselung und einen Teilabschnitt, der durch die Primärschicht verläuft. Mittels der weiteren Durchkontaktierung ist es in vorteilhafter Weise möglich, von der Außenseite der Verkapselung eine direkte elektrische Verbindung zu der metallischen Zwischenschicht zwischen der Primärschicht und der Sekundärschicht zur realisieren.

In einer weiteren Ausführungsform der vorliegenden Erfindung ist es vorgesehen, dass in der Verkapselung eine zwischen der Außenseite der Verkapselung und der Bauteilseite des Trägersubstrats angeordnete Kontaktierungsebene vorgesehen ist, die zum Verbinden mindestens zweier Durchkontaktierungen schräg und/oder quer zur Erstreckungsrichtung/Verlaufsrichtung der Durchkontaktierungen verläuft. Dadurch lassen sich mehrere Durchkontaktierungen miteinander elektrisch verbinden, so dass der Bereich innerhalb der Verkapselung bereits als Verteilsystem, d. h. als dreidimensionales Leitersystem, genutzt werden kann. Ferner ist es vorstellbar mittels der Kontaktierungsebene die weitere Durchkontaktierung mit einer oder mehreren Durchkontaktierungen zu verbinden. Vorzugsweise erstrecken sich die Kontaktierungsebenen parallel zur Haupterstreckungsebene des Trägersubstrats und sind als zusätzliche strukturierte Metallisierungsschicht ausgebildet. Zur Fertigung solcher Kontaktierungsebenen ist es beispielsweise vorstellbar, dass die Verkapselung mehrteilig zusammensetzbar ist oder in mehreren aufeinanderfolgenden Spritzguss - und/oder Spritzpressenvorgängen realisiert wird. Weiterhin gestatten die Kontaktierungsebenen auf einfache Weise einen lateralen Versatz zwischen dem ersten Bauteil und dem zweiten Bauteil zu realisieren, insbesondere ohne schräg zur Stapelrichtung verlaufende Durchkontaktierungen.

Erfindungsgemäß ist es vorgesehen, dass das Trägersubstrat an seiner der Bauteilseite gegenüberliegenden Seite eine Kühlstruktur aufweist, wobei das Elektronikmodul vorzugsweise ein Dichtelement und/oder Dichtmaterial, z. B. ein Silikon, für ein fluiddichtes Anbinden an eine Fluidkühlungsvorrichtung aufweist. Erfindungsgemäß ist die Kühlstruktur in vorteilhafter Weise in das Trägersubstrat integriert und wird von der Verkapselung nicht umschlossen, d. h. liegt frei. Die Integration gestattet einen geringen Aufwand beim Verbauen des Elektronikmoduls, da in vorteilhafter Weise auf einen zusätzlichen Arbeitsschritt, in dem eine Bodenplatte und/oder ein Kühler an das Trägersubstrat angebunden wird, beispielsweise gelötet, gesintert und/oder verklemmt wird, verzichtet werden kann. Die Fluidkühlvorrichtung dient insbesondere dem Heran - und Abführen eines Kühlfluids, insbesondere einer Kühlflüssigkeit. Vorzugsweise umfasst die Kühlstruktur Finnen, die in einen Kanal hineinragen, der von der Kühlstruktur und der Fluidkühlungsvorrichtung ausgebildet wird. Zum Abdichten des Kanals, der zwischen trägersubstratseitigen Kühlstruktur und Fluidkühlungsvorrichtung ausgebildet wird, ist vorzugsweise ein Dichtelement vorgesehen, das in das Elektronikmodul integriert ist, vorzugsweise im Wesentlichen in Stapelrichtung gesehen auf Höhe der Kühlstruktur angeordnet ist. Vorzugsweise ist das Dichtelement ringartig oder als Wulst ausgebildet und umläuft vorzugsweise die Kühlstruktur, insbesondere die Finnen der Kühlstruktur. Vorzugsweise ist das Dichtelement an der Verkapselung angeordnet, beispielsweise in einer hierfür vorgesehenen Nut.

Ein weiterer Vorteil, der sich durch Integration der Kühlstruktur unmittelbar an das Trägersubstrat ergibt, ist, dass man auf Material zwischen der Kühlstruktur und dem Trägersubstrat bzw. der Sekundärschicht verzichten kann. Solch ein **TIM** (thermal interface material) Material weist in der Regel eine gegenüber den übrig verwendeten Materialen im Trägersubstrat reduzierte Wärmleitfähigkeit auf. Der Verzicht auf das **TIM** Material und das Vermeiden von Grenzflächen verbessert den thermischen Widerstand des Trägersubstrats bzw. des Elektronikmoduls signifikant.

In einer weiteren Ausführungsform der vorliegenden Erfindung ist es vorgesehen, dass die Durchkontaktierung eine Länge zwischen 0,1 und 15 mm, bevorzugt zwischen 0,15 und 8 mm und besonders bevorzugt zwischen 0,2 und 5 mm aufweist. Es hat sich in vorteilhafter Weise herausgestellt, das mit derartig kurzen Leiterpfaden bzw. Durchkontaktierungen, der Einfluss von parasitären Induktivitäten deutlich reduzieren lässt und die Ansteuerung der ersten elektronischen Bauteil durch die zweiten elektronischen Bauteile so verbessert wird.

Ein weiterer Gegenstand der vorliegenden Erfindung ist ein Verfahren zur Herstellung eines Elektronikmoduls, insbesondere eines erfindungsgemäß Elektronikmoduls, umfassend:
- Bereitstellen eines mit einem ersten elektronischen Bauteil bestückten Trägersubstrats, wobei das erste elektronische Bauteil an einer ersten Metallisierungsschicht des Trägersubstrats angebunden ist,
- zumindest teilweise Verkapseln des bestückten Trägersubstrats mit einem Verkapselung
- Ausbilden einer Durchkontaktierung in der Verkapselung zum Bereitstellen einer elektrischen Verbindung zwischen dem ersten elektronischen Bauteil und einem zweiten elektronischen Bauteil an einer Außenseite der Verkapselung und
- Ausbilden einer zweiten Metallisierungsschicht, insbesondere strukturierten zweiten Metallisierungsschicht, für das zweite elektronische Bauteil an der Außenseite der Verkapselung.

Alle für das erfindungsgemäße Metall-Keramik-Substrat beschriebenen Merkmale und deren Vorteile lassen sich sinngemäß ebenfalls auf das erfindungsgemäße Verfahren übertragen und vice versa. Insbesondere ist es vorgesehen, dass über die Durchkontaktierung die zweite Metallisierungsschicht mit dem ersten Bauteil und/oder der ersten Metallisierungsschicht verbunden wird.

Zum Bereitstellen des Trägersubstrats werden beispielsweise eine Primärschicht, eine Sekundärschicht, eine Zwischenschicht, eine erste Metallisierungsschicht und/oder eine Kühlstruktur in einem gemeinsamen Anbindungsverfahren miteinander verbunden. Dabei können auch unterschiedliche Anbindungsverfahren verwendet werden. Als Anbindungsverfahren kommen z. B. DCB- (direct copper bonding) oder DAB (direct aluminium bonding)-Verfahren , in Frage oder das Verbinden mittels eines Aktivlots, d. h. ein AMB (active metal brazing) - Verfahren.

Zur Ausbildung der Durchkontaktierung ist es vorzugsweise vorgesehen, dass in die gefertigte Verkapselung eine Aussparung, insbesondere eine Bohrung, eingelassen wird. Diese wird vorzugsweise mittels Laserlicht realisiert. Es ist aber auch vorstellbar, dass die Bohrung bzw. für die Durchkontaktierung in die Verkapselung ein durchgreifendes Loch eingefräst wird. Sofern Laserlicht verwendet wird, bildet sich vorzugsweise eine in Richtung des Trägersubstrats verjüngende Aussparung, beispielsweise eine konusförmige Verjüngung. Um die Durchkontaktierung richtig zu platzieren, lässt sich ein Rand der Verkapselung oder eine Kennzeichnung als Referenz verwenden. Im Anschluss an die gefertigte Aussparung wird die Aussparung mit einem leitfähigen Material vollständig oder teilweise gefüllt. Beispielsweise lässt sich eine Paste aus einem leitfähigen Material in die Durchkontaktierung einführen und anschließend wird die Paste ausgehärtet.

Vorzugsweise werden die ersten elektronischen Bauteile so präpariert bzw. bereitgestellt, dass sie eine Kontaktfläche aufweisen, die im am Trägersubstrat verbauten Zustand auf die Außenseite bzw. der Durchkontaktierung zugewandt sind. Dabei ist es vorstellbar, dass Kontaktierungslöcher in das erste elektronische Bauteil eingelassen werden und Anschlusskontaktierung mittels physikalischer Gasphasenablagerung realisiert werden. Anschließend wird die Anschlusskontaktierung durch ein chemisches Ablagern, beispielsweise mittels einer Galvanotechnik, verstärkt. Vorzugsweise werden die ersten elektronischen Bauteile bzw. Gruppierungen aus ersten elektronischen Bauteilen mit den gewünschten Kontaktflächen bereitgestellt.

Vorzugsweise ist es vorgesehen, dass die Verkapselung mittels eines Spritzguss - und/oder Spritzpressverfahrens geformt wird, insbesondere um das bestückte Trägersubstrat herum geformt wird. Insbesondere wird die Verkapselung in einem Spritzguss - und/oder Spritzpressenformteil geformt. Dabei wird vorzugsweise das bestückte Trägersubstrat, insbesondere an der Bauteilseite, mit dem Spritzguss - und/oder Spritzpressenmaterial bedeckt, nachdem es in das Spritzguss - und/oder Spritzpressenformteil eingesetzt wurde. Als Spritzguss - und/oder Spritzpressenverfahren ist beispielsweise ein Transfermolding, ein Kompressionsmolding und/oder ein Flüssigvergussverfahren vorstellbar. Sofern eine oder mehrere Kontaktierungsebenen vorgesehen sind, ist es vorstellbar, dass die Verkapselung in mehreren aufeinander folgenden Spritzguss - und/oder Spritzpressenvorgängen realisiert wird, wobei zwischen jedem dieser Spritzguss **-** und/oder Spritzpressenvorgängen eine Kontaktierungsebene mit oder ohne weitere Bauelemente realisiert wird, indem eine strukturierte Metallisierungsschicht auf den zuletzt gegossenen Abschnitt der Verkapselung aufgebracht wird.

In einer weiteren Ausführungsform der vorliegenden Erfindung ist es vorgesehen, dass die zweite Metallisierungsschicht auf der Außenseite der Verkapselung
- durch eine während des Spritzguss - und/oder Spritzpressenverfahrens in eine Spritzguss **-** und/oder Spritzpressenform eingelegte Metallfolie,
- durch eine physikalische Gasphasenabscheidung und/oder
- elektrochemische Abscheidung realisiert wird. Insbesondere dient die elektrochemische Abscheidung, beispielsweise mittels Galvanotechnik, der Verstärkung derjenigen Struktur, die durch die Metallfolie bzw. die physikalische Gasphasenabscheidung bereits begonnen bzw. initiiert wurde. Beispielsweise wird die durch Gasphasenabscheidung oder die Metallfolie bereitgestellte Struktur durch galvanisches Kupfer verstärkt, insbesondere nach oder vor einer Strukturierung. Dabei wird bei der Gasphasenabscheidung beispielsweise eine Schablone verwendet. Sofern eine Metallfolie zur Realisierung der zweiten Metallisierungsschicht vorgesehen ist, ist es vorstellbar, dass diese Metallfolie bereits strukturiert ist. Alternativ oder ergänzend ist es denkbar, dass die zweite Metallisierungsschicht nach ihrer Fertigung strukturiert wird. Ferner ist es auch vorstellbar, dass die zweite Metallisierungsschicht auf der Verkapselung aufgeklebt wird. Weiterhin ist es vorstellbar, dass die zweite Metallisierungsschicht mittels eines Druckverfahrens, insbesondere eines 3D-Druckverfahrens, aufgetragen wird. Ferner ist es denkbar, dass nach dem Bereitstellen der zweiten Metallisierungsschicht diese nachbearbeitet wird. Beispielsweise wird die zweite Metallisierungsschicht versiegelt (mit Gold; Silber, ENIG) und/oder lötbar gemacht.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Einzelne Merkmale der einzelnen Ausführungsformen

können dabei im Rahmen der Erfindung miteinander kombiniert werden. Es zeigt:
- **Fig.1:**: ein Elektronikmodul gemäß einer ersten beispielhaften Ausführungsform der vorliegenden Erfindung,
- **Fig. 2:**: ein Elektronikmodul gemäß einer zweiten beispielhaften Ausführungsform der vorliegenden Erfindung,
- **Fig. 3:**: schematisch ein Verfahren zur Herstellung eines Elektronikmoduls gemäß einer beispielhaften Ausführungsform der vorliegenden Erfindung und
- **Fig. 4.**: ein Beispiel für eine Fertigung eines Vorverbundes.

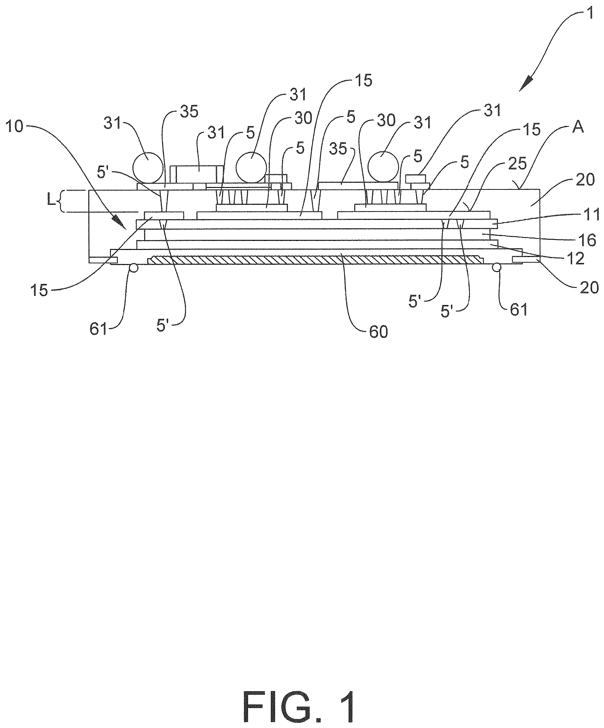

In der **Figur 1** ist ein Elektronikmodul 1 gemäß einer ersten beispielhaften Ausführungsform der vorliegenden Erfindung dargestellt. Wesentliche Bestandteile eines solchen Elektronikmoduls 1 sind ein Trägersubstrat 10 und eine Verkapselung 20, wobei das Trägersubstrat 10 zumindest teilweise in die Verkapselung 20 eingebettet ist, d. h. das Trägersubstrat 10 ist zumindest teilweise in das Verkapselung 20 eingekapselt. Das Trägersubstrat 10 weist eine Bauteilseite 25 mit einer ersten Metallisierungsschicht 15 auf, wobei die erste Metallisierungsschicht 15 zur Bildung von Leiterbahnen oder Anschlusspads strukturiert ist. An der Bauteilseite 25 sind erste elektronische Bauteile 30 angebunden, die zur Ausbildung zumindest eines Teils eines elektronischen Schaltkreises vorzugsweise untereinander verbunden sind. Beispielsweise umfassen die erste elektronischen Bauteile Halbleiter, insbesondere WBG -Halbleiter (wide bandgap semiconductors), wie z. B. einem Halbleiter aus Siliziumcarbid, Galliumnitrid und/oder Indiumgalliumnitrid, deren Bandlücke zwischen einem Valenzband und dem Leitungsband zwischen 2 eV und 4 eV oder darüber liegt. Insbesondere ist das Elektronikmodul 1 ein Leistungselektronikmodul und dient beispielsweise der Umformung elektrischer Energie mit schaltenden elektronischen Bauteilen. Denkbar wäre z. B. dass das Elektronikmodul als Gleichspannungswandler, Umrichter und/oder Frequenzumrichter im Bereich der elektronischen Antriebstechnik, insbesondere im Bereich der E-mobilität, als Solarwechselrichter und/oder Umrichter für Windkraftanlagen zur Netzeinspeisung regenerativ erzeugter Energie oder als Schaltnetzteil bzw. DC-DC-Wandler eingesetzt wird.

Zur Steuerung der ersten elektronischen Bauteile 30 auf der Bauteilseite 25 ist an der Außenseite A der Verkapselung 20 eine insbesondere als Anschluss dienende zweite Metallisierungsschicht 35 für mindestens ein zweites elektronisches Bauteil oder Kontaktelement 31 vorgesehen. Vorzugsweise ist die zweite Metallisierungsschicht 35 ebenfalls strukturiert. Beispielsweise handelt es sich bei dem zweiten elektronischen Bauteil 31 um ein Steuerungselement, wie z. B. einen Gate-Treiber, ein Zwischenkondensator, ein Lastanschluss, ein Anschluss zur Energieversorgung oder Vergleichbares. Zum Bereitstellen einer unmittelbaren elektrischen Verbindung der ersten elektrischen Bauteile 30 und der zweiten elektronischen Bauteile 31 ist in der Verkapselung 20 zumindest eine Durchkontaktierung 5 vorgesehen. Dabei erstreckt sich die Durchkontaktierung 5 von der Außenseite A der Verkapselung 20 bis zur Bauteilseite 25 des Trägersubstrats 10.

Vorzugsweise ist es vorgesehen, dass mittels der Durchkontaktierung 5 ein Abstand zwischen dem ersten elektrischen Bauteil 30 an der Bauteilseite 25 und dem zweiten elektrischen Bauteil 31 an der Außenseite A geringer als 10 mm, bevorzugt 5 mm, besonders bevorzugt 2,5 mm, insbesondere 1 mm bis hin zu weniger als 300 µm, d. h. möglichst gering, dimensioniert wird. Eine Länge L der Durchkontaktierung 5 entspricht dabei vorzugsweise dem Abstand zwischen dem ersten Bauteil 30 und dem zweiten Bauteil 31.

Vorzugsweise umfasst das Trägersubstrat 10 eine Primärschicht 11, eine Sekundärschicht 12 und eine zwischen der Primärschicht 11 und der Sekundärschicht 12 angeordnete metallische Zwischenschicht 16. Hierbei erstrecken sich die Primärschicht 11, die Sekundärschicht 12 und die Zwischenschicht 16 entlang einer Haupterstreckungsebene HSE und sind entlang einer senkrecht zur Haupterstreckungsebene HSE verlaufenden Stapelrichtung S übereinander angeordnet. Dabei dient die metallische Zwischenschicht 16 vorzugsweise als elektrischer Rückleiter, wodurch mit Vorteil parasitäre Induktivitäten reduziert werden können. Während die Primärschicht 11 und/oder die Sekundärschicht 12 primär zur Versteifung des Trägersubstrats 10 vorgesehen sind, dient die Zwischenschicht 16, neben ihrer optionalen Funktion als elektrischer Rückleiter (wenn eine Durchkontaktierung durch die Primärschicht vorliegt), insbesondere als Wärmsenke bzw. temporärer Wärmespeicher, in der eine (zusätzliche) Wärmspreizung erfolgt. Als temporärer Wärmespeicher verbessert die Zwischenschicht eine thermische Impedanz Zₜₕ des Trägersubstrats. Die Wärmespreizung führt in vorteilhafter Weise auf eine homogener Temperaturverteilung auf einer der Bauteilseite 25 des Trägersubstrats 10 gegenüberliegenden Seite des Trägersubstrats 10, über die die von den ersten Bauteilen entwickelte Wärme über eine Kühlstruktur 60 oder eine andere Kühlvorrichtung abgeleitet werden soll. Vorzugsweise ist die Zwischenschicht 16 hierzu dicker als die Primärschicht 11 und/oder die Sekundärschicht 12 ist und/oder dicker als 1 mm, bevorzugt dicker als 1,5 und besonders bevorzugt dicker als 2,5 mm ist.

Vorzugsweise sind die thermischen Ausdehnungskoeffizienten bzw. die Ausdehnung der einzelnen Komponenten des Elektronikmoduls 10 derart gewählt, dass der thermische Ausdehnungskoeffizient in Stapelrichtung S gesehen im Wesentlichen symmetrisch ist bzw. möglichst symmetrisch ist. Bei einer Nutzung der metallischen Zwischenschicht 16 mit einer Dicke größer als 1 mm und der Verwendungen dünnerer Primärschichten 11 bzw. Sekundärschichten 12, insbesondere aus Keramik, ist es dann in vorteilhafter Weise möglich für das Trägersubstrat 10 einen vergleichsweise hohen thermischen Ausdehnungskoeffizienten CTE zu realisieren. Dieser vergleichsweise hohe thermische Ausdehnungskoeffizient vereinfacht die Anpassung des thermischen Ausdehnungskoeffizienten der Verkapselung 20, der andernfalls mittels eines entsprechenden Füllmaterials gesenkt werden müsste. Infolgedessen lässt sich in vorteilhafter Weise die Materialkosten für das Füllmaterial reduzieren.

Für eine möglichst kompakte Bauform sorgt insbesondere die Verkapselung 20.

Insbesondere ist die Verkapselung derart gestaltet, dass die Verkapselung form-, kraft- und/oder formschlüssig mit dem Trägersubstrat 10 im zusammengesetzten Zustand zusammenwirkt. Vorzugsweise ist das Trägersubstrat 10 zumindest an seiner Bauteilseite 25 eingebettet in die Verkapselung 20, d. h. die Verkapselung umschließt die Bauteilseite 25 vollständig. In der in Figur 1 dargestellten Ausführungsform ist erfindungsgemäß auf einer der Bauteilseite 25 gegenüberliegenden Seite eine Kühlstruktur 60 vorgesehen. Insbesondere umfasst die Kühlstruktur 60 Finnen. Weiterhin ist es vorgesehen, dass die Kühlstruktur 60 nicht von der Verkapselung 20 umhüllt ist, d. h. die Kühlstruktur bzw. deren Finnen liegen frei. Stattdessen ist die Kühlstruktur 60 zur unmittelbaren Anbindung an eine Fluidkühlungsvorrichtung, beispielswiese einen entsprechenden Kanal, der ein Kühlfluid zur Kühlstruktur hin und wegführt, vorgesehen. Zum Abdichten eines Fluidkanals, der zwischen der Fluidkühlungsstruktur und der trägersubstratseitigen Kühlstruktur 60 ausgebildete wird, ist ein Dichtelement 61 vorgesehen. Vorzugsweise ist das Dichtelement 61 umlaufend in einer parallel zur Haupterstreckungsebene HSE verlaufenden Ebene ausgestaltet.

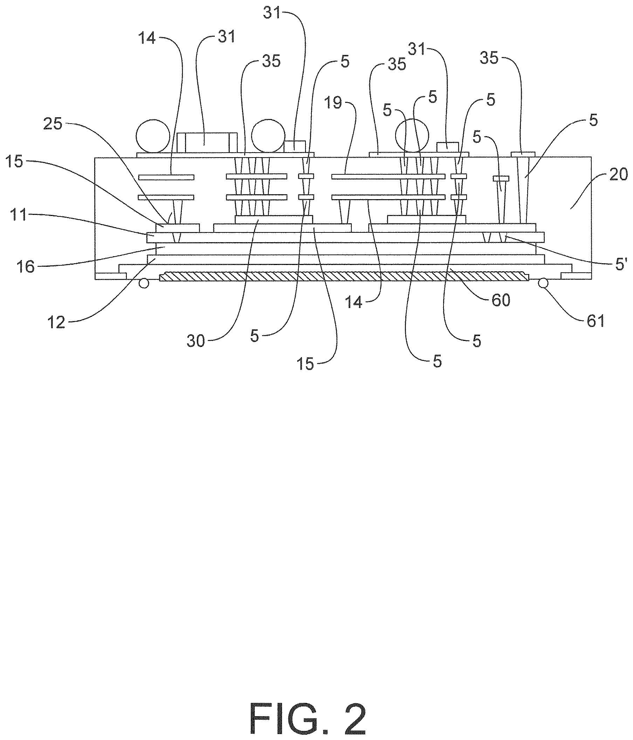

In **Figur 2** ist schematisch ein Elektronikmodul 10 gemäß einer zweiten Ausführungsform der vorliegenden Erfindung dargestellt. Die Ausführungsform aus der Figur 2 unterscheidet sich im Wesentlichen von derjenigen aus Figur 1 nur dahingehend, dass in der Verkapselung 20 mehrere Kontaktierungsebenen 14 vorgesehen sind. Diese Kontaktierungsebenen 14 erstrecken sich im Wesentlichen schräg bzw. quer zur Verlaufsrichtung der Durchkontaktierungen 5, wobei die Verlaufsrichtung in der dargestellten Ausführungsform parallel zur Stapelrichtung verläuft. Es ist aber auch vorstellbar, dass die Verlaufsrichtung der Durchkontaktierung schräg zur Stapelrichtung S verläuft. Über die Kontaktierungsebenen 14 können mehrere Durchkontaktierungen 5 miteinander in vorteilhafter Weise verbunden werden. Vorzugsweise verlaufen mehrere der weiteren Kontaktierungsebenen 14 parallel zueinander, insbesondere parallel zur Haupterstreckungsebene.

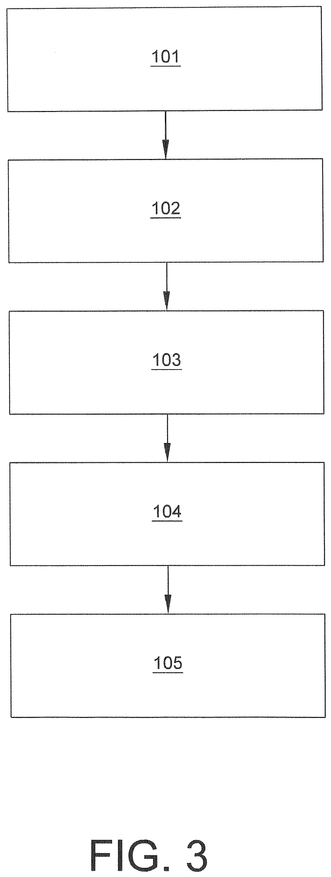

In **Figur 3** ist schematisch ein Verfahren zur Herstellung einer Elektronikmoduls 10 dargestellt. Dabei ist es vorgesehen, dass zunächst ein Trägersubstrat 10 bereitgestellt wird. Insbesondere werden zum Bereitstellen 101 des Trägersubstrats 10 die metallische Zwischenlage 16 und/oder eine Kühlstruktur 60 für das Trägersubstrat vorbereitet. Anschließend werden die Primärschicht 11, die Sekundärschicht 12, die metallische Zwischenschicht 16 und/oder die Kühlstruktur 60 in einem gemeinsamen oder mehreren einzelnen Anbindungsprozessen miteinander verbunden. Bei dem Anbindungsprozess handelt es sich vorzugsweise um ein DCB oder DAB Verfahren oder ein Verbinden mittels eines Aktivlots. Zum Bereitstellen von Leiterbahnen und Anschlussflächen wird die erste Metallisierungsschicht 15 auf der Bauteilseite 25 strukturiert, beispielsweise durch einen Ätzprozess. Vorzugsweise wird die Bauteilseite 25 anschließend oberflächenmodifiziert, indem ein Vernickelung, ein Versilbern, ein Kantenverguss oder etwas Vergleichbares erfolgt.

Weiterhin ist es vorgesehen, dass die ersten elektronischen Bauteile 20 zur Anbindung an die Bauteilseite 25 für das Elektromodul 10 vorbereitet und beispielsweise als Vorverbund bereitgestellt werden. Insbesondere werden an den elektronischen Bauteilen 30 Kontakte derart realisiert, dass die Kontakte in einem im Elektronikmodul 1 verbauten Zustand der Außenseite A der Verkapselung 20 zugewandt sind. Hierzu werden Kontaktierungslöcher in dem Vorverbund eingebracht. Die eingebrachten Kontaktierungen lassen sich mittels physikalischer Gasphasenabscheidung verkupfern und anschließend zur Verstärkung galvanisieren.

Nach dem Fertigstellen des Trägersubstrats 10 wird der Vorverbund auf der strukturierten Metallisierungsschicht 15 an der Bauteilseite 25 des Trägersubstrats 10 befestigt, beispielsweise angelötet oder aufgesintert. Das mit dem Vorverbund bestückte Trägersubstrats 10 wird anschließend verkapselt. Vorzugsweise wird zum Verkapseln 102 ein Spritzguss - und/oder Spritzpressenverfahren verwendet. Hierzu wird das bestückte Trägersubstrat in eine Spitgussform eingelegt. Vorzugsweise ist die Spitzgussform so ausgestaltet, dass die Kühlstruktur 60 von einem beim Spritzgießen zu füllenden Hohlraum abgewandt ist. So wird die Kühlstruktur 60 beim Spritzguss - und/oder Spritzpressenverfahren nicht vom beim Spritzguss und/oder Spritzpressen verwendeten Kunststoff bedeckt.

Weiterhin ist es vorgesehen, dass eine Ausbildung 103 einer Durchkontaktierung der Verkapselung 20 erfolgt, indem beispielsweise mittels Laserlichts eine Aussparung, insbesondere ein Loch bzw. eine Bohrung, in der Verkapselung 5 realisiert wird. Dabei sind die Löcher und Bohrungen im Wesentlichen konisch geformt. Diese konische Form resultiert typischerweise aus einer Fokussierung eines Laserstrahls mit dem die Aussparung realisiert wird. Weiterhin ist es vorgesehen, dass das Loch bzw. die Bohrung zur Bildung der Durchkontaktierung 5 mit einem Metall gefüllt wird, beispielsweise unter Verwendung einer Paste. Zur Orientierung an der Außenseite A beim Realisieren der Bohrungen sind vorzugsweise Kennzeichnungen vorgesehen. Vorzugsweise handelt es sich bei der Kennzeichnung um in die Verkapselung 20 gefräste Löcher, die beispielsweise auch zur Ausrichtung der Verkapselung 20 vor dem Realisieren der Löcher dienen können.

Weiterhin ist vorstellbar, dass in eine verwendete Spitzgussform, mit der die Verkapselung gebildet wird, eine Metallfolie eingelegt wird, die nach dem Spritzguss und/oder Spritzpressen die zweite Metallisierungsschicht 35 für die zweiten elektronischen Bauteile 31 bereitstellt. Ergänzend oder alternativ ist es vorstellbar, dass die zweite Metallisierungsschicht 35 nach dem Spritzguss **-** und/oder Spritzpressenverfahren auf der spitzgegossenen Verkapselung 20 mittels eines physikalischen Gasphasenabscheidungsverfahren oder einem 3D Druckverfahren hergestellt wird. Vorzugsweise wird die zweite Metallisierungsschicht durch ein mittels Galvanotechnik aufgetragenes Metall, beispielsweise durch galvanisch aufgetragenes Kupfer, verstärkt.

Zum Ausbilden der Metallisierungsschicht 104 gehört vorzugsweise ein Strukturieren der zweiten Metallisierungsschicht 35 an der Außenseite A. Es ist auch vorstellbar, dass ein Lötstopplack verwendet und/oder die zweite Metallisierungsschicht 35 an der Außenseite A nachbehandelt wird. Als Nachbehandlung ist beispielsweise eine Oberflächenmodifikation 105 in Form eine Versiegelung mit ENIG (Electroless nickel immersion gold), Silber oder Gold vorstellbar. Vorzugsweise wird das zweite elektronische Bauteil 31 schließlich an der hierfür vorgesehenen zweiten Metallisierungsschicht 35 an der Außenseite A montiert. Weiterhin ist es vorgesehen, dass ein Deckelelement am Elektronikmodul 10 befestigt wird und das bereitgestellte Elektronikmodul einer Endkontrolle unterzogen wird.

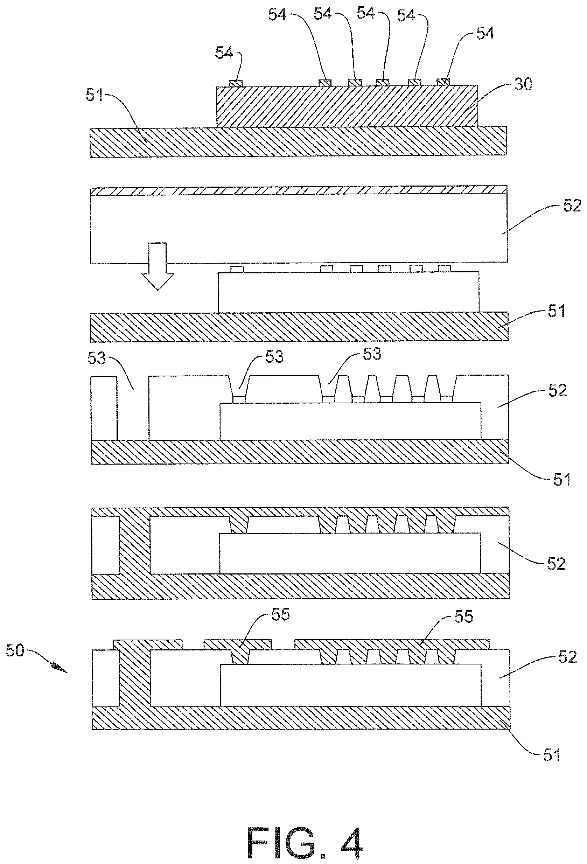

In **Figur 4** ist schematisch und beispielhaft ein Verfahren zur Fertigung eines Vorverbunds 50 dargestellt. Dabei ist es vorgesehen dass ein erstes Bauteil 30 mit bauteilseitigen Anschlüssen 54 auf einer Leiterplatte 51 aufgebracht wird. Anschließend werden die Leiterplatte 51 und das erste Bauteil 30 derart laminiert, dass das erste Bauteil 30 innerhalb einer Matrix 52, beispielsweise einer dielektrischen Matrix 52, angeordnet bzw. eingebettet ist. Zum Freilegen der bauteilseitigen Anschlüsse 54 wird die dielektrische Matrix 52 strukturiert. Dadurch ergeben sich Aussparungen 53, die bis zur Leiterplatte 51 oder zu den elektrischen Anschlüssen 54 ragen. Diese Aussparungen 53 werden mit einem leitenden Material verfüllt, wobei auch die Außenseite der dielektrischen Matrix 52 bedeckt wird.

Dann wird das leitende Material an der Außenseite strukturiert, um die vorverbundseitigen Kontaktflächen 55 bereitzustellen. Diese vorverbundseitigen Kontaktflächen 55 stellen die Kontaktflächen der ersten Bauteile innerhalb der Verkapselung 20 dar und stehen mit der Durchkontaktierung 5 der Verkapselung 20 in Kontakt. Der Vorteil der Nutzung des Vorverbunds 50 besteht mitunter in der Realisierung von vorverbundseitigen Kontaktflächen 55, die größer sind als die bauteilseitigen Anschlüsse 53. So kann beispielsweise verhindert werden, dass wegen eines fertigungsbedingten Versatzes der nachträglich in die Verkapselung 20 eingelassene Durchkontaktierungen 5 keine Kontaktierung mit dem ersten Bauteil 30 realisiert werden kann.

### Bezugszeichenliste:

- 1: Elektronikmodul
- 5: Durchkontaktierung
- 5': weitere Durchkontaktierung
- 10: Trägersubstrat
- 11: Primärschicht
- 12: Sekundärschicht
- 15: erste Metallisierungsschicht
- 16: Zwischenschicht
- 20: Verkapselung
- 25: Bauteilseite
- 30: erstes elektronisches Bauteil
- 31: zweites elektronisches Bauteil
- 35: zweite Metallisierungsschicht
- 50: Vorverbund
- 51: Leiterplatte
- 52: Matrix
- 53: Aussparung
- 54: bauteilseitige Anschlüsse
- 55: verbundseitige Anschlüsse
- 60: Kühlstruktur
- 61: Dichtelement
- 101: Bereitstellen eines Trägersubstrats
- 102: Verkapseln
- 103: Ausbilden einer Durchkontaktierung
- 104: Ausbilden einer strukturierten zweiten Metallisierungsschicht
- 105: Oberflächenmodifikation
- A: Außenseite
- L: Länge

## Patentansprüche

1. Elektronikmodul (1), umfassend
- eine Verkapselung (20) und
- ein in die Verkapselung (20) eingebettetes Trägersubstrat (10) mit einer Bauteilseite (25), die eine erste Metallisierungsschicht (15) aufweist und an der mindestens ein erstes elektronisches Bauteil (30) angeordnet ist, wobei das erste elektronische Bauteil (30) von der Verkapselung (20) umschlossen ist und wobei das Trägersubstrat (10) ein Metall-Keramik-Substrat ist, wobei an einer Außenseite (A) der Verkapselung (20) mindestens eine zweite Metallisierungsschicht (35) für mindestens ein zweites elektronisches Bauteil (31), insbesondere zur Steuerung des ersten elektronischen Bauteils (30), vorgesehen ist,
wobei die Verkapselung (20) mindestens eine Durchkontaktierung (5) zur elektrischen Verbindung, insbesondere zur unmittelbaren elektrischen Verbindung, des ersten elektronischen Bauteils (30) und des zweiten elektronischen Bauteils (31) aufweist,
wobei eine Außenfläche des Trägersubstrats (10) zu mehr als 50 % von der Verkapselung bedeckt ist, **dadurch gekennzeichnet, dass** das Trägersubstrat (10) an seiner der Bauteilseite (25) gegenüberliegenden Seite eine Kühlstruktur (60) aufweist, wobei die Kühlstruktur in das Trägersubstrat integriert ist und nicht von der Verkapselung umschlossen wird.

2. Elektronikmodul (1) gemäß Anspruch 1, wobei die zweite Metallisierungsschicht (35) strukturiert ist und/oder wobei ein senkrecht zur Haupterstreckungsebene bemessener Abstand zwischen der ersten Metallisierungsschicht (15) und der zweiten Metallisierungsschicht (35) geringer als 1 mm ist.

3. Elektronikmodul (1) gemäß einem der vorhergehenden Ansprüche, wobei das Trägersubstrat eine Primärschicht (11), eine Sekundärschicht (12) und eine zwischen der Primärschicht (11) und der Sekundärschicht (12) angeordnete metallische Zwischenschicht (16)als elektronischen Rückleiter aufweist, wobei die Zwischenschicht (16) vorzugsweise
- dicker als die Primärschicht (11) und/oder die Sekundärschicht (12) ist und/oder
- dicker als 1 mm ist.

4. Elektronikmodul (1) gemäß Anspruch 3, wobei zur elektrischen Verbindung der Zwischenschicht (16) mit dem ersten und/oder zweiten elektronischen Bauteil (30, 31) eine weitere Durchkontaktierung (5') vorgesehen ist, wobei die weitere Durchkontaktierung (5') zumindest durch die Primärschicht (11) verläuft.

5. Elektronikmodul (1) gemäß einem der vorhergehenden Ansprüche, wobei in der Verkapselung (20) eine zwischen der Außenseite (A) der Verkapselung (20) und der Bauteilseite (25) des Trägersubstrats (10) angeordnete Kontaktierungsebene (14) vorgesehen ist, die zum Verbinden mindestens zweier Durchkontaktierungen (5) schräg und/oder quer zur Erstreckungsrichtung der Durchkontaktierungen (5) verläuft.

6. Elektronikmodul (1) gemäß einem der vorhergehenden Ansprüche, wobei das Elektronikmodul (1) ein Dichtelement (61) für ein fluiddichtes Anbinden an eine Fluidkühlungsvorrichtung aufweist.

7. Elektronikmodul (1) gemäß einem der vorhergehenden Ansprüche, wobei die Durchkontaktierung (5) eine Länge (L) zwischen 0,2 und 5 mm aufweist.

8. Elektronikmodul (1) gemäß einem der vorhergehenden Ansprüche, wobei die Durchkontaktierung (5) jeweils einen in einer parallel zur Haupterstreckungsebene (HSE) bemessenen Richtung bemessenen Querschnitt von weniger als 5 mm² aufweist.

9. Elektronikmodul (1) gemäß einem der vorhergehenden Ansprüche, wobei die Verkapselung (20) aus einer Epoxid-Vergusskomponente als Verkapselungsmaterial gefertigt ist.

10. Elektronikmodul (1) gemäß einem der vorhergehenden Ansprüche, wobei die Durchkontaktierung (5) schräg zu einer senkrecht zur Haupterstreckungsebene (HSE) des Trägersubstrats (10) erstreckenden Richtung verläuft.

11. Verfahren zur Herstellung eines Elektronikmoduls (1) gemäß einem der vorhergehenden Ansprüche, umfassend:
- Bereitstellen (101) eines mit einem ersten elektronischen Bauteil (30) bestückten Trägersubstrats (10), wobei das erste elektronische Bauteil (30) an einer ersten Metallisierungsschicht (15) des Trägersubstrats (10) angebunden ist,
- Verkapseln (102) des bestückten Trägersubstrats (10) mit einer Verkapselung (20), wobei das erste elektronische Bauteil (30) von der Verkapselung (20) umschlossen wird, wobei das Trägersubstrat (10) ein Metall-Keramik-Substrat ist und wobei eine Außenfläche des Trägersubstrats (10) zu mehr als 50 % von der Verkapselung bedeckt wird,
- Ausbilden (103) einer Durchkontaktierung (5) in der Verkapselung (20) zum Bereitstellen einer elektrischen Verbindung zwischen dem ersten elektronischen Bauteil (30) und einem zweiten elektronischen Bauteil (31) an einer Außenseite (A) der Verkapselung und
- Ausbilden (104) einer zweiten Metallisierungsschicht (35) für das zweite elektronische Bauteil (31) an der Außenseite (A) der Verkapselung (20), **dadurch gekennzeichnet, dass** das Trägersubstrat (10) an seiner der Bauteilseite (25) gegenüberliegenden Seite eine Kühlstruktur (60) aufweist, wobei die Kühlstruktur in das Trägersubstrat integriert ist und nicht von der Verkapselung umschlossen wird.

12. Verfahren gemäß Anspruch 11, wobei die Verkapselung (20) mittels eines Spritgussverfahrens geformt wird.

13. Verfahren gemäß Anspruch 11, wobei die zweite Metallisierungsschicht (35) auf der Außenseite (A) der Verkapselung (20)
- durch eine während eines Spritzguss - und/oder Spritzpressenverfahrens in eine Spritzguss - und/oder Spritzpressenform eingelegte Metallfolie.
- durch eine physikalische Gasphasenabscheidung und/oder
- elektrochemische Abscheidung realisiert wird.

## Claims

1. An electronic module (1), comprising
- an encapsulation (20) and
- a carrier substrate (10) embedded in the encapsulation (20) and having a component side (25) which has a first metallisation layer (15) and on which at least a first electronic component (30) is arranged, wherein the first electronic component (30) is enclosed by the encapsulation (20) and wherein the carrier substrate (10) is a metal-ceramic substrate,
wherein at least one second metallisation layer (35) is provided on an outer side (A) of the encapsulation (20) for at least one second electronic component (31), in particular for controlling the first electronic component (30),
wherein the encapsulation (20) has at least one via (5) for the electrical connection, in particular for the direct electrical connection, of the first electronic component (30) and the second electronic component (31), wherein an outer surface of the carrier substrate (10) is covered by more than 50% by the encapsulation, **characterised in that** that the carrier substrate (10) has a cooling structure (60) on its side opposite the component side (25), wherein the cooling structure is integrated into the carrier substrate and is not enclosed by the encapsulation.

2. The electronic module (1) according to claim 1, wherein the second metallisation layer (35) is structured and/or wherein a distance between the first metallisation layer (15) and the second metallisation layer (35), measured perpendicular to the main extension plane, is less than 1 mm.

3. The electronic module (1) according to one of the preceding claims, wherein the carrier substrate has a primary layer (11), a secondary layer (12) and a metallic intermediate layer (16) arranged between the primary layer (11) and the secondary layer (12) as an electronic return, wherein the intermediate layer (16) is preferably
- thicker than the primary layer (11) and/or the secondary layer (12) and/or
- thicker than 1 mm.

4. The electronic module (1) according to claim 3, wherein a further via (5') is provided for the electrical connection of the intermediate layer (16) to the first and/or second electronic component (30, 31), wherein the further via (5') runs at least through the primary layer (11).

5. The electronic module (1) according to one of the preceding claims, wherein a contact plane (14) is provided in the encapsulation (20) between the outer side (A) of the encapsulation (20) and the component side (25) of the carrier substrate (10), which runs obliquely and/or transversely to the direction of extension of the vias (5) for joining at least two vias (5).

6. The electronic module (1) according to one of the preceding claims, wherein the electronic module (1) has a sealing element (61) for fluid-tight bonding to a fluid cooling device.

7. The electronic module (1) according to one of the preceding claims, wherein the via (5) has a length (L) between 0.2 and 5 mm.

8. The electronic module (1) according to one of the preceding claims, wherein the via (5) has a cross-section of less than 5 mm² in a direction measured parallel to the main extension plane (HSE).

9. The electronic module (1) according to one of the preceding claims, wherein the encapsulation (20) is made of an epoxy casting component as encapsulation material.

10. The electronic module (1) according to one of the preceding claims, wherein the via (5) runs obliquely to a direction extending perpendicular to the main extension plane (HSE) of the carrier substrate (10).

11. A method for producing an electronic module (1) according to one of the preceding claims, comprising:
- providing (101) a carrier substrate (10) equipped with a first electronic component (30), the first electronic component (30) being bonded to a first metallisation layer (15) of the carrier substrate (10),
- encapsulating (102) of the equipped carrier substrate (10) with an encapsulation (20), wherein the first electronic component (30) is enclosed by the encapsulation (20), wherein the carrier substrate (10) is a metal-ceramic substrate and wherein an outer surface of the carrier substrate (10) is covered by more than 50% by the encapsulation,
- forming (103) a via (5) in the encapsulation (20) for providing an electrical connection between the first electronic component (30) and a second electronic component (31) on an outer side (A) of the encapsulation, and
- forming (104) a second metallisation layer (35) for the second electronic component (31) on the outer side (A) of the encapsulation (20), **characterised in that** the carrier substrate (10) has a cooling structure (60) on its side opposite the component side (25), wherein the cooling structure is integrated into the carrier substrate and is not enclosed by the encapsulation.

12. The method according to claim 11, wherein the encapsulation (20) is formed by means of an injection moulding process.

13. The method according to claim 11, wherein the second metallisation layer (35) is realized on the outer side (A) of the encapsulation (20)
- by a metal foil inserted into an injection mould and/or injection press mould during an injection moulding and/or injection press process,
- by physical vapour deposition and/or
- electrochemical deposition.

## Revendications

1. Module électronique (1), comprenant
- une encapsulation (20) et
- un substrat de support (10), encastré dans l'encapsulation (20), avec une face composant (25) qui présente une première couche de métallisation (15) et sur laquelle est disposé au moins un premier composant électronique (30), le premier composant électronique (30) étant entouré par l'encapsulation (20) et le substrat de support (10) étant un substrat métal-céramique,
au moins une deuxième couche de métallisation (35) pour au moins un deuxième composant électronique (31), en particulier pour la commande du premier composant électronique (30), étant prévue sur une face extérieure (A) de l'encapsulation (20),
l'encapsulation (20) présentant au moins un via (5) pour la connexion électrique, en particulier pour la connexion électrique directe du premier composant électronique (30) et du deuxième composant électronique (31),
une surface extérieure du substrat de support (10) étant recouverte à plus de 50 % par l'encapsulation,
**caractérisé en ce que** le substrat de support (10) présente une structure de refroidissement (60) sur sa face opposée à la face composant (25), la structure de refroidissement étant intégrée dans le substrat de support et n'étant pas entourée par l'encapsulation.

2. Module électronique (1) selon la revendication 1,
dans lequel la deuxième couche de métallisation (35) est structurée et/ou une distance entre la première couche de métallisation (15) et la deuxième couche de métallisation (35), mesurée perpendiculairement au plan d'extension principal, est inférieure à 1 mm.

3. Module électronique (1) selon l'une des revendications précédentes,
dans lequel le substrat de support comprend une couche primaire (11), une couche secondaire (12) et une couche intermédiaire métallique (16) disposée entre la couche primaire (11) et la couche secondaire (12) et servant de conducteur de retour électronique, la couche intermédiaire (16) étant de préférence
- plus épaisse que la couche primaire (11) et/ou la couche secondaire (12), et/ou
- plus épaisse que 1 mm.

4. Module électronique (1) selon la revendication 3,
dans lequel un autre via (5') est prévu pour la connexion électrique de la couche intermédiaire (16) avec le premier et/ou le deuxième composant électronique (30, 31), l'autre via (5') s'étendant au moins à travers la couche primaire (11).

5. Module électronique (1) selon l'une des revendications précédentes,
dans lequel un plan de mise en contact (14) disposé entre la face extérieure (A) de l'encapsulation (20) et la face composant (25) du substrat de support (10) est prévu dans l'encapsulation (20), lequel s'étend en oblique et/ou transversalement par rapport à la direction d'extension des vias (5) pour connecter au moins deux vias (5).

6. Module électronique (1) selon l'une des revendications précédentes,
dans lequel le module électronique (1) comporte un élément d'étanchéité (61) pour un raccordement étanche aux fluides à un dispositif de refroidissement par fluide.

7. Module électronique (1) selon l'une des revendications précédentes,
dans lequel le via (5) présente une longueur (L) comprise entre 0,2 et 5 mm.

8. Module électronique (1) selon l'une des revendications précédentes,
dans lequel le via (5) présente une section transversale respective, dimensionnée dans une direction parallèle au plan d'extension principal (HSE), inférieure à 5 mm².

9. Module électronique (1) selon l'une des revendications précédentes,
dans lequel l'encapsulation (20) est fabriquée à partir d'un composant de scellement en époxy à titre de matériau d'encapsulation.

10. Module électronique (1) selon l'une des revendications précédentes,
dans lequel le via (5) s'étend en oblique par rapport à une direction perpendiculaire au plan d'extension principal (HSE) du substrat de support (10).

11. Procédé de fabrication d'un module électronique (1) selon l'une des revendications précédentes, consistant à :
- fournir (101) un substrat de support (10) équipé d'un premier composant électronique (30), le premier composant électronique (30) étant raccordé à une première couche de métallisation (15) du substrat de support (10),
- encapsuler (102) le substrat de support équipé (10) avec une encapsulation (20), le premier composant électronique (30) étant entouré par l'encapsulation (20), le substrat de support (10) étant un substrat métal-céramique, et une surface extérieure du substrat de support (10) étant recouverte à plus de 50 % par l'encapsulation,
- ménager (103) un via (5) dans l'encapsulation (20) pour assurer une connexion électrique entre le premier composant électronique (30) et un deuxième composant électronique (31) sur une face extérieure (A) de l'encapsulation, et
- former (104) une deuxième couche de métallisation (35) pour le deuxième composant électronique (31) sur la face extérieure (A) de l'encapsulation (20), **caractérisé en ce que** le substrat de support (10) présente une structure de refroidissement (60) sur sa face opposée à la face composant (25), la structure de refroidissement étant intégrée dans le substrat de support et n'étant pas entourée par l'encapsulation.

12. Procédé selon la revendication 11,
dans lequel l'encapsulation (20) est formée par un procédé de moulage par injection.

13. Procédé selon la revendication 11,
dans lequel la deuxième couche de métallisation (35) sur la face extérieure (A) de l'encapsulation (20) est réalisée par
- une feuille métallique qui est insérée dans un moule de moulage par injection et/ou de moulage par compression-transfert pendant un procédé de moulage par injection et/ou de moulage par compression-transfert,
- un dépôt physique en phase vapeur, et/ou
- un dépôt électrochimique.
